# EUROPÄISCHE PATENTANMELDUNG

(11) **EP 2 230 497 A1**
(43) Veröffentlichungstag der Anmeldung: **22.09.2010**
(21) Anmeldenummer: 10165732.8
(22) Anmeldetag: 09.06.2008
(51) Int. Cl.: G01J 5/20, H01L 31/0352, H01L 31/103, H01L 31/105, H01L 21/20

(54) **Diodenbolometer und ein Verfahren zur Herstellung eines Diodenbolometers**

(62) Teilanmeldung aus: 08759120.2
(71) Anmelder: Fraunhofer-Gesellschaft zur Förderung der Angewandten Forschung e.V., 80686 München (DE)
(72) Erfinder: Kropelnicki, Piotr, 50668 Köln (DE); Russ, Marco, 46145 Oberhausen (DE); Vogt, Holger, 45481 Mülheim (DE)
(74) Vertreter: Schenk, Markus

(57) **Zusammenfassung**

Ein Bolometer weist eine Halbleitermembran (110) mit einem einkristallinen Abschnitt (120) und Abstandshaltern (150a,150b), um die Halbleitermembran (110) in einem vorbestimmten Abstand (D) von einem Untergrundsubstrat (160) zu halten, auf. Die komplementär dotierte Bereiche (120a, 120b) des einkristallinen Abschnitts bilden eine Diode und der vorbestimmte Abstand (D) entspricht einem Viertel einer Infrarotwellenlänge (λ).
Zumindest ein Teil einer Ausleseschaltung ist in dem Untergrundsubstrat (160) lateral zwischen dem ersten und zweiten Abstandhalter (150a,150b) angeordnet.

## Beschreibung

Die vorliegende Erfindung bezieht sich auf ein Diodenbolometer und ein Verfahren zur Herstellung eines Diodenbolometers und insbesondere auf ein Diodenbolometer mit einer reduzierten thermischen Ankopplung und auf ein Herstellungsverfahren mit hoher Justagetoleranz.

Die Detektion von infraroter Strahlung gewinnt in vielen unterschiedlichen Bereichen zunehmend an Bedeutung. Für die Automobilindustrie liegt diese Bedeutung in der Erreichung einer höheren Sicherheit von beispielsweise Fußgängern, die mit Infrarotsensoren auch in dunkler Umgebung sichtbar gemacht werden können. Koppelt man ein automatisches Bremssystem an eine Sensorik, können dadurch Unfälle vermieden oder deren Auswirkung zumindest gemildert werden. Weitere Anwendungen von Infrarotsensoren umfassen beispielsweise die Inspektion von technischen Geräten (z. B. elektrische Leitungen oder auch Leiterplatinen) oder Gebäuden. In der Zukunft können auch medizinische Anwendungen relevant werden. Schon jetzt werden Infrarotsensoren in den Bereichen der Gebäude-, Gelände- und Grenzüberwachung eingesetzt.

Für viele dieser Anwendungen ist die erreichbare Auflösung von minimalen Temperaturunterschieden ein wichtiges Qualitätskriterium des verwendeten Messinstrumentes. Diese Sensitivität wird in kommerziellen Geräten zumeist als NETD (= noise equivalent temperature difference) angegeben und es werden in ungekühlten Bolometern Werte von beispielsweise unterhalb 100 mK Temperaturunterschied erreicht. Die Bezeichnung dieser Kenngröße macht auch gleich die interne Begrenzen von Sensoren deutlich, die durch die Rauscheigenschaften des verwendeten Systems gegeben ist. Verwendet man beispielsweise als Detektormaterial eine dünne Membran als Sensor, die sich unter dem Einfluss der Infrarotstrahlung aufheizt und dabei ihren elektrischen Widerstand ändert, so bestimmen die elektrischen Eigenschaften dieses Systems, welche Widerstands- (und damit Temperatur-) Änderungen noch detektiert und vom Rauschuntergrund separiert werden können. Ist die durch die Temperaturänderung induzierte Änderung des Widerstands des Materials kleiner als das Rauschen der elektrischen Parameter, so wird sie nicht mehr aufgelöst.

In vielen homogenen amorphen Sensormaterialien (wie beispielsweise Silizium, Vanadiumoxid usw.) ist die prozentuale Widerstandsänderung proportional zur Temperaturänderung. Die Proportionalitätskonstante ist dabei im Wesentlichen durch die Wahl des Materials und die Prozessparameter gegeben, wobei ihrer Optimierung im Allgemeinen enge Grenzen gesetzt sind. Typische Werte für die Widerstandsänderung liegen in einem Bereich von etwa 2 bis 3 % pro K.

Sofern die Widerstandsänderung durch die Materialeigenschaften des Sensors gegeben sind, bleiben noch zwei weitere wesentliche Möglichkeiten, in größerem Maße auf die Sensoreigenschaften einzuwirken. Eine erste Möglichkeit besteht darin, die Sensorelemente möglichst groß zu machen. Je größer die für den Sensor und die zugehörigen thermischen Isolationsbereiche zur Verfügung stehende Fläche ist, desto mehr Strahlung kann absorbiert werden, bzw. desto mehr Strahlungsenergie wird in eine Temperaturerhöhung des Sensors umgewandelt. Dieser Ansatz weist natürlich den entscheidenden Nachteil auf, dass damit nicht dem zunehmenden Wunsch nach einer Miniaturisierung und damit Verbilligung der Bauelemente Rechnung getragen werden kann.

Sofern das Ziel darin besteht, aus Kostengründen bei konstanter Baugröße das Signal/Rausch-Verhältnis zu optimieren, bleibt als weiterer Ansatz noch die Möglichkeit, das Rauschen zu minimieren. In elektronischen Bauelementen gibt es unterschiedliche Rauschquellen. In amorphen Materialien dominiert in der Regel das so genannte 1/f-Rauschen, bei dem die Rauschleistungsdichte umgekehrt proportional zur Frequenz f ist. Dies ist insofern ein schwerwiegendes Problem, als z. B. die üblicherweise verwendeten integrativen Ausleseschaltungen (Tiefpass) nicht geeignet sind, die dominierenden niederfrequenten Anteile des Rauschens zu unterdrücken.

Eine Möglichkeit dieses Problem zu umgehen, besteht darin, einkristallines Material wie beispielsweise Silizium zu verwenden. In diesen Materialien ist das 1/f-Rauschen in der Regel nicht dominant, und durch eine Integration des Messsignals kann ein gutes Signal/Rausch-Verhältnis erreicht werden. Dieser Vorteil wird jedoch üblicherweise mit einer stark verringerten Abhängigkeit des Widerstands von der Temperatur erkauft. Beispielsweise kann die Temperaturabhängigkeit des Widerstandswerts einen Wert von 0,3 % pro K aufweisen.

Aus diesem Grunde kann es vorteilhaft sein auch einkristalline Dioden als Infrarotsensoren zu verwenden. Eine ideale Diode hat eine exponentielle Temperaturabhängigkeit des Widerstands und das Rauschen wird durch das Schrotrauschen bestimmt, welches durch eine geeignete Integrationszeit limitiert werden kann. Das Schrotrauschen hängt im Wesentlichen nur von der Frequenzbandbreite der Messung ab und erst bei höheren Frequenzen zeigt sich eine 1/f²-Abhängigkeit. Dioden sind somit ein sehr viel versprechendes Sensorelement, da sie ein großes Signal mit einem kleinen Rauschen vereinigen. Allerdings ist die Integration von thermisch isolierten Dioden in einem CMOS-Prozess durchaus aufwändig. Der zunächst verwendete Ansatz, die isolierten Dioden durch geeignete Unterätzungen direkt im CMOS-Wafer zu fertigen, weist den Nachteil auf, sehr flächenintensiv zu sein - ohne dabei brauchbare Isolations-und Absorptionseigenschaften zu vereinen.

Beispielsweise erlauben diese Techniken es nicht, unterhalb der Sensorstruktur aktive CMOS-Ansteuer- und Verstärkerelemente zu integrieren. Die vielleicht mögliche Integration dieser Elemente seitlich neben dem Detektor führt zu einer starken Reduktion des Füllfaktors (Detektorfläche zur Gesamtfläche) und erhöht dadurch die Schippfläche und die Detektorkosten. Zudem ist es nicht möglich, mit diesen Strukturen einen Absorber herzustellen, der eine Widerstandsschicht mit einem Schicht- oder Flächenwiderstand von rund 377 Ohm/□ (ungefährer Ausbreitungswiderstand einer elektromagnetischen Welle in Luft) aufweist und gleichzeitig in einer Höhe von λ/4 (d.h. rund 2,5 µm bei der bevorzugten IR-Wellenlänge λ) über einen Reflektor angeordnet ist.

Die DE 10 2006 028 435 A1 befasst sich mit einem Infrarotsensor und Verfahren zu seiner Herstellung, wobei insbesondere auch monokristallines Halbleitermaterial genutzt wird, um eine Diode als temperaturabhängiges Sensorelement auszubilden. Unterhalb des Sensorelements wird ein Hohlraum durch ein herkömmliches Ätzverfahren herausgebildet. Das Sensorelement gehört somit zu der Klasse von Sensorelementen, bei denen nachteilig ist, dass der Sensorbereich von dem Schaltungsbereich lateral getrennt ist.

Die WO 2007/104328 A1 beschreibt ein Bolometer mit organischen Halbleiterschichtanordnungen.

Die DE 196 33 849 A1 offenbart einen Infrarotdetektor und ein Herstellungsverfahren, wobei der Infrarotdetektor ebenfalls einen pn-Übergang nutzt, um einen temperaturabhängigen Sensor zu realisieren.

Die US 6,483,111 B1 offenbart einen thermischen Infrarotsensor oder ein Infrarotsensorarray, bei dem einkristallines Silizium genutzt wird, um eine Diode in dem Sensorbereich auszubilden.

Ausgehend von diesem Stand der Technik liegt der vorliegenden Erfindung die Aufgabe zugrunde, ein Diodenbolometer zu schaffen, das eine reduzierte thermische Ankopplung bei gleichzeitig hoher Sensitivität und hohen Füllfaktor aufweist. Gleichzeitig soll ein Herstellungsverfahren geschaffen werden, das eine Realisierung einer Auswerte- und Steuerschaltung unterhalb der Sensormembran ermöglicht.

Diese Aufgabe wird durch eine Vorrichtung nach Anspruch 1 und ein Verfahren nach Anspruch 13 gelöst.

Der Kerngedanke der vorliegenden Erfindung besteht darin, ein Bolometer mit einer Halbleitermembran mit einem einkristallinen Abschnitt zu schaffen, wobei komplementär dotierte Bereiche des einkristallinen Abschnitts eine Diode bilden. Die dadurch erhaltene Membran wird mittels Abstandshalter in einem vorbestimmten Abstand vor einem Untergrundsubstrat gehalten, wobei jene Gebiete der Membran, an denen die Abstandshalter die Membran fixieren, amorphisiert sind, so dass die thermische Leitfähigkeit in diesen Gebieten abgesenkt ist. Um die elektrische Leitfähigkeit entlang der amorphen Bereiche zu erhöhen, kann optional eine zusätzliche leitfähige Schicht entlang der Membran angeordnet sein. Die leitfähige Schicht kann gleichzeitig dazu genutzt werden, den Flächenwiderstand der Membran entsprechend anzupassen - z.B. in einem Bereich zwischen 200 und 700 Ohm/Quadratfläche oder z.B. an den Ausbreitungswiderstand der elektromagnetische Welle in Luft.

Der vorliegenden Erfindung liegt ebenfalls die Erkenntnis zugrunde, dass ein Herstellungsverfahren für ein Bolometer eine Prozessierung eines Sensorwafers und eine Prozessierung eines Schaltungswafers umfasst und beide Wafer nach deren Prozessierung miteinander gebondet werden. Dadurch kann erreicht werden, dass die Hochtemperaturprozesse, die beim Prozessieren des Sensorwafers erforderlich sind, eine in dem Substrat unterhalb der Membran angeordnete Schaltung weder zerstören noch negativ beeinflussen können.

Die Möglichkeit, die Ausleseschaltung und die Dioden in verschiedenen Wafern zunächst zu fertigen und beide Wafer anschließend durch ein so genanntes Wafer-to-Wafer-Bonding zusammenzuführen, bringt sehr viele Vorteile mit sich, da dadurch u.a. ein hoher Füllfaktor bei gleichzeitiger geringer Justagetoleranz erreicht werden kann.

Im einfachsten Fall weist somit der Sensorwafer, der auf die Schaltungselektronik gebondet wird, nur eine Schicht aus unterschiedlich dotiertem Halbleitermaterial wie beispielsweise Silizium auf. Da in diesem Fall jedoch weder die optischen, noch die elektrischen Parameter optimal sind, sind weitere Modifizierungen sinnvoll. Ein Ziel dabei ist die einfache Diodenstruktur so zu modifizieren, dass der Sensor (Infrarotsensor) einen großen Teil der einfallenden Strahlung absorbiert und die absorbierte Energie zu einer Maximaltemperaturerhöhung führt und die damit verbundene Änderung des Messsignals möglichst groß wird.

Ausführungsbeispiele können dadurch eine Reihe von Problemen lösen. So wird es mit der hier vorgestellten Prozessführung möglich, einkristalline Dioden zur Infrarotdetektion zu verwenden, ohne gleichzeitig Einbußen bei der thermischen Isolierung oder den optischen Eigenschaften in Kauf nehmen zu müssen. Während der Sensor selbst einkristallin ist, erfolgt die thermische Ankopplung über schlecht wärme leitende amorphe Bereiche. Auch bei der Prozessführung zur Herstellung der Dioden werden die bisher nötigen Beschränkungen aufgehoben, da die Dioden nicht in einem empfindlichen CMOS-Wafer gebildet werden, sondern in einem separaten Sensorwafer, der nach Prozessierung durch Bonden mit dem CMOS-Wafer zusammengeführt wird.

Die Erfindung erzielt somit die folgenden Verbesserungen:
- Dioden aus einkristallinem Halbleitermaterial können als Detektoren verwendet werden, wodurch ein geringes Rauschen erreicht werden kann;
- eine hervorragende thermische Isolierung wird beispielsweise durch die amorphisierten Kontakte erreicht;
- hervorragende optische Eigenschaften;
- geringe thermische Masse und damit kleine Zeitkonstanten;
- gute elektrische Eigenschaften (durch einen relativ geringen Widerstand); und
- skalierbare Geometrien (da z. B. die Auswerteschaltung unterhalb der Membran angeordnet sein kann).

Im Vergleich zu Ausführungsbeispielen der vorliegenden Erfindung sind konventionelle Bolometer mit Dioden in einem Verfahren realisiert worden, so dass die Bolometer eine große Zeitkonstante, eine geringe Isolierung und nur ein schlechtes Absorptionsverhalten aufweisen. Beispielsweise sind Dioden unterhalb der Membran derart angeordnet, dass dadurch kein λ/4-Absorber realisierbar ist - zumindest kein Absorber, bei dem sich die Membran in einem Abstand von ca. 2,5 µm über einen darunter liegenden Untergrund aufgehängt ist. Dieser Wert würde jedoch einer typisch zu detektierenden IR-Wellenlänge von λ∼10 µm (von einem Körper bei Zimmertemperatur) entsprechen.

Ausführungsbeispiele umfassen ebenfalls ein Herstellungsverfahren für ein einkristallines Diodenbolometer mit reduzierter thermischer Ankopplung, wobei für die Herstellung des gebondeten Diodenbolometers, das eine optimierte thermische, elektrische und optische Eigenschaften aufweist, folgende Prozessschritte ausgeführt werden können.

Zunächst wird ein Wafer mit der Ausleseschaltung (read out integrated circuit = ROIC) prozessiert. Dieser Wafer weist in den Bereichen, in denen später der elektrische Kontakt zum Sensorwafer hergestellt wird, Kontaktflächen auf. Die Ausleseschaltung kann besonders einfach sein, da die Dioden selbst schon einen zur Adressierung benutzbaren Schalter darstellen.

In einem zweiten Schritt kann ein weiterer Wafer (Sensorwafer) mit den zum Array angeordneten Diodenbolometern gefertigt werden. Als Substrat kann beispielsweise ein so genannter SOI-Wafer (SOI = silicon on insulator) verwendet werden. Die Verwendung eines SOI-Wafers ist jedoch optional und alternativ können auch andere Wafer entsprechend verwendet werden. Der SOI-Wafer zeichnet sich dadurch aus, dass auf einer dicken Siliziumschicht eine Schicht aus Oxid (vergrabene Oxidschicht) gefolgt von einer weiteren Schicht aus einem einkristallinen Silizium vorliegt.

Mit einem beispielhaften LOCOS-Prozess (LOCOS = local oxidation of Silicon) kann beispielsweise der Wafer in zwei Bereichen mit unterschiedlich dickem einkristallinem Silizium unterteilt werden. Der dickere Bereich kann dabei beispielsweise später die Sensorschicht bilden und erlaubt einen höheren Stromfluss, während die dünnen Bereiche (Kontaktbereiche) eine optimierte thermische Isolierung erlauben.

Nach einer weiteren Oxidation (bspw. Streuoxid) kann nun das Dotierprofil implantiert (n- und p-Bereiche) und thermisch ausgeheilt werden. Die dünnen Kontaktbereiche können nun noch durch den Beschuss mit einem nicht dotierenden Material, wie beispielsweise Argon, amorphisiert werden. Nach einigen weiteren Schritten kann nun auf weite Teile des Detektors ein dünnes, leitfähiges Material abgeschieden werden, das beispielsweise Titannitrid aufweist. Dadurch werden Reflektionen vermieden und gleichzeitig die elektrisch schlecht leitenden Bereiche des amorphisierten Siliziums elektrisch überbrückt. Die Schichtfolge kann dann optional mit einer geeigneten Passivierung versehen werden.

Da die Kontaktbereiche amorphisiert und dünner als die eigentlich sensorisch aktiven Bereiche sind, wird eine thermische Entkopplung des Sensorbereichs erzielt. Der Sensorbereich bleibt dabei gleichzeitig einkristallin und hat damit im Vergleich zu vollständig amorphen Sensormaterialien massiv verbesserte Rauscheigenschaften.

Die weitere Prozessführung kann nun von der gewählten Technik zum Verbinden der beiden Wafer abhängig sein. In der präferierten Prozessführung wird der Sensorwafer mit einem Siliziumoxid versehen und dann direkt in einem Waferbonder mit dem Schaltungswafer mit der Ausleseschaltung verbunden. Von den zusammen gebondeten Wafern wird nun das nicht mehr benötigte Substrat des Sensorwafers entfernt, was beispielsweise durch einen so genannten Grinding-Prozess mit abschließendem chemischen Ätzen bis zu der vergrabenen Oxidschicht geschehen kann. Dieses vergrabene Oxid kann dann ebenfalls komplett entfernt und durch eine frei zu wählende Passivierungsschicht ersetzt werden. Diese Passivierungsschicht wird dann beispielsweise so strukturiert, dass die Bereiche über den Kontaktbereichen des ROIC freigelegt werden.

In einem weiteren Ätzschritt können bis hinunter auf die Kontaktflächen des ROIC Löcher geätzt werden, die anschließend mit einem Metall aufgefüllt werden. Abschließend kann in einem weiteren Ätzprozess die Sensorgeometrie hergestellt werden (beispielsweise die Definition der einzelnen Bolometerpixel). Die nun nicht mehr benötigten Zwischenschichen können dann chemisch entfernt werden. Handelt es sich bei den Zwischenschichten beispielsweise um Siliziumoxid, kann zum Ätzen beispielsweise ein HF-Dampf verwendet werden.

Zum Verbinden (Bonden) der beiden Wafer (Schaltungswafer und Sensorwafer) gibt es eine Reihe von weiteren Methoden, wie beispielsweise die Verwendung von klebenden Zwischenschichten (z. B. Polyimid).

Somit beschreiben Ausführungsbeispiele einen einkristallinen Diodenbolometer mit reduzierter thermischer Ankopplung, wobei die einkristalline Ausgestaltung der Membran ein hervorragendes Rausch/Signal-Verhältnis sicherstellt und die reduzierte thermische Ankopplung durch amorphisierte Randbereiche, an denen die Membran fixiert wird, sicherstellt.

Bevorzugte Ausführungsbeispiele der vorliegenden Erfindung werden nachfolgend Bezug nehmend auf die beiliegenden Zeichnungen näher erläutert. Es zeigen:
- Fig. 1a,b: Querschnittsansichten durch einen Diodenbolometer gemäß Ausführungsbeispielen der vorliegenden Er- findung;
- Fig. 2a bis 2f: Querschnittsansichten für eine Prozessfolge des Sensorwafers;
- Fig. 3a,b: Prinzipdarstellungen des Waferbondprozesses; und
- Fig. 4: eine Draufsicht auf einen Sensorarray mit bei- spielsweise sechs Pixeln.
Bevor im Folgenden die vorliegende Erfindung anhand der Zeichnungen näher erläutert wird, wird darauf hingewiesen, dass gleiche Elemente in den Figuren mit gleichen oder ähnlichen Bezugszeichen versehen sind, und dass eine wiederholte Beschreibung dieser Elemente weg gelassen wird.

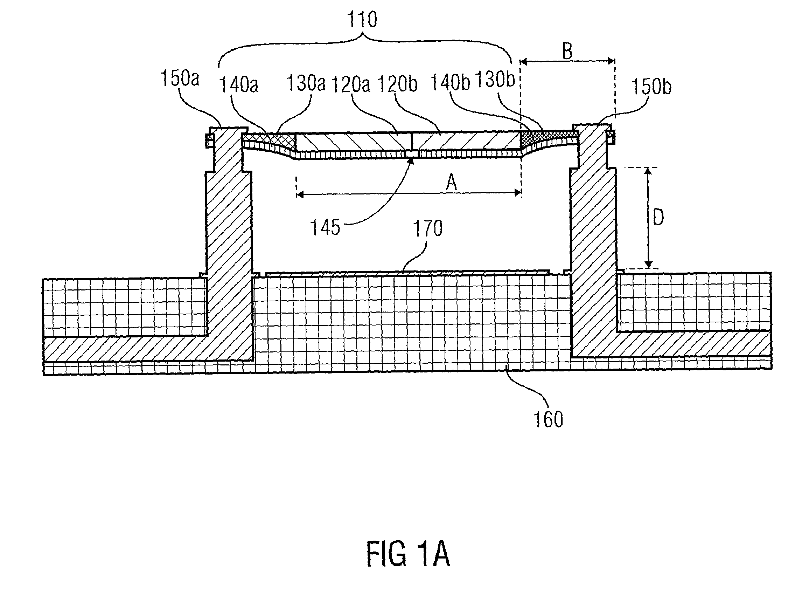

Fig. 1a zeigt eine Querschnittsansicht durch ein Bolometer gemäß einem Ausführungsbeispiel der vorliegenden Erfindung, wobei das Bolometer eine Halbleitermembran 110 aufweist, die von zwei Abstandshaltern 150a, b in einem vorbestimmten Abstand D von einem Untergrundsubstrat 160 gehalten wird. Die Halbleitermembran 110 weist einen einkristallinen Abschnitt 120 auf, wobei komplementär dotierte Bereiche 120a, b des einkristallinen Abschnitts 120 eine Diode bilden. Ferner weist die Halbleitermembran 110 einen ersten amorphisierten Bereich 130a, der in Verbindung mit dem ersten Abstandshalter 150a steht und einen zweiten amorphisierten Bereich 130b, der in einem Kontakt mit dem zweiten Abstandshalter 150b steht, auf. Auf der dem Untergrundsubstrat 160 zugewandten Seite der Membran 110 ist eine leitfähige Schicht 140 ausgebildet, wobei die leitfähige Schicht 140 wiederum einen ersten Teil 140a, der in elektrischem Kontakt mit dem ersten Abstandshalter 150a steht, aufweist und ferner ein zweiter Teil 140b in leitfähigem Kontakt mit dem zweiten Abstandshalter 150b steht. Der erste und zweite Teil der leitfähigen Schicht 140a, b ist durch einen Spalt 145 elektrisch voneinander isoliert, wobei der erste Teil der leitfähigen Schicht 140a den ersten dotierten Bereich 120a elektrisch kontaktiert und der zweite Teil der leitfähigen Schicht 140b den zweiten dotierten Bereich 120b elektrisch kontaktiert. Die Abstandshalter 150a, b definieren dabei zum einen den vorbestimmten Abstand D der Membran 110 über dem Untergrundsubstrat 160 und ferner bieten die Abstandshalter 150 einen mechanischen Halt als auch eine elektrische Kontaktierung der Membran 110.

Um eine bessere thermische Isolation oder Abschirmung des durch die dotierten Bereiche 120a, b definierten Sensorbereich A zu erreichen, sind Kontaktbereiche B um die Abstandshalter 150 ausgebildet, wobei die Kontaktbereiche B beispielsweise durch eine Amorphisierung von einkristallinen Halbleitermaterial erzeugt werden können. Um einen möglichst effizienten Infrarotsensor zu realisieren, ist es vorteilhaft, den vorbestimmten Abstand D derart zu wählen, dass sich ein λ/4-Absorber ergibt, d. h. dass der vorbestimmte Abstand D einem Viertel einer Infrarotwellenlänge entspricht (D = λ/4) . Um einen λ/4-Absorber zu realisieren, ist ferner eine Reflexionsschicht 170 auf dem Untergrundsubstrat 160 ausgebildet, so dass einfallende und von der Reflexionsschicht 170 reflektierte Infrarotwellen effizient absorbiert werden können, was zu einer Erwärmung der Membran 110 führt. Die Erwärmung der Membran 110 in Folge der Absorption der einfallenden Infrarotstrahlung kann dann durch eine Änderung des elektrischen Widerstands entlang des pn-Überganges der komplementär dotierten Bereiche 120a und 120b gemessen werden. Dazu kann sich beispielsweise in dem Untergrundsubstrat 160 eine Auswerteschaltung 180 befinden (in der Fig. 1a nicht gezeigt).

Die leitfähige Schicht 140 dient zum einen der besseren Kontaktierung der komplementär dotierten Bereiche 120a, b (da durch die Amorphisierung der Kontaktbereiche B deren Leitfähigkeit herabgesetzt wurde) als auch der Einstellung des Schichtwiderstands der Membran 110, die optimalerweise dem Wellenwiderstand von Luft entsprechen sollte (d. h. ca. 377 Ohm/sq.). Als Halbleitermaterial kann beispielsweise Silizium verwendet werden und die komplementär dotierten Bereiche können durch eine Bor- bzw. Phosphor-Implantierung erreicht werden (so dass sich ein n-leitendes und ein p-leitendes Gebiet ergibt).

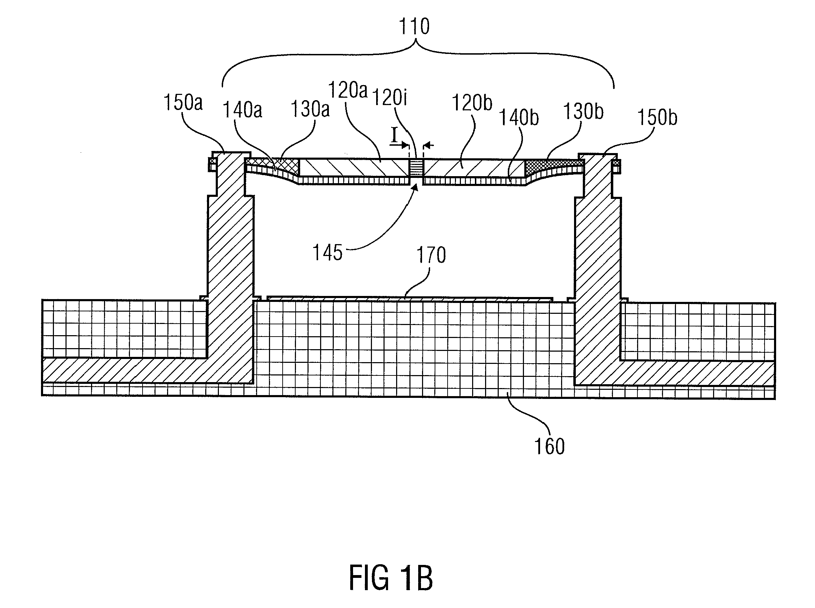

Fig. 1b zeigt eine Querschnittsansicht durch ein Bolometer gemäß einem weiteren Ausführungsbeispiel, wobei das Bolometer wiederum eine Halbleitermembran 110 aufweist, bei der im Unterschied zu der Halbleitermembran 110 aus der Fig. 1a zwischen den komplementär dotierten Bereichen 120a,b ein intrinsischer Abschnitt 120i ausgebildet ist. Der intrinsische Abschnitt 120i weist keine oder eine schwache (p- oder n-) Dotierung auf und ist beispielsweise aus dem gleichen Halbleitermaterial gebildet wie der einkristalline Abschnitt 120. Der intrinsische Abschnitt 120i kann beispielsweise oberhalb oder entlang des Spaltes 145 ausgebildet sein, wobei der Spalt 145 wiederum den ersten und zweiten Teil der leitfähigen Schicht 140a, b voneinander elektrisch isoliert. Der intrinsische Abschnitt 120i kann also lateral entlang der gesamten Halbleitermembran 110 ausgebildet sein, so dass ein elektrischer Strom, der zwischen dem ersten und zweiten Abstandshalter 150a,b fließt, den intrinsischen Abschnitt 120i passiert. Senkrecht zu dem möglichem Stromfluss weist der intrinsische Abschnitt 120i eine laterale Ausdehnung I auf, die derart gewählt sein kann, dass sich eine PIN-Diode entlang der Halbleitermembran 110 herausbildet. Sofern der intrinsische Abschnitt 120i schwach p- oder schwach n-dotiert ist, sollte die Stärke dieser Dotierung deutlich unterhalb der Dotierung der komplementär dotierten Bereiche 120a,b liegen (z.B. mindestens unterhalb von 10% oder weniger als 1%).

Alle weiteren Merkmale des Ausführungsbeispiels wie es in Fig. 1b gezeigt ist, stimmen mit dem Ausführungsbeispiel aus Fig. 1a überein und eine wiederholte Beschreibung wird deshalb hier weggelassen.

Somit umfassen weitere Ausführungsbeispiele ebenfalls ein Bolometer, bei dem der sensorisch aktive Teil in Form einer Diode ausgeführt ist, die mindestens zwei komplementär (p oder n) dotierte Bereiche 120a,b aufweist und optional dazwischen einen oder mehrere Bereiche mit reduzierter Dotierstoffkonzentration ausgebildet sind.

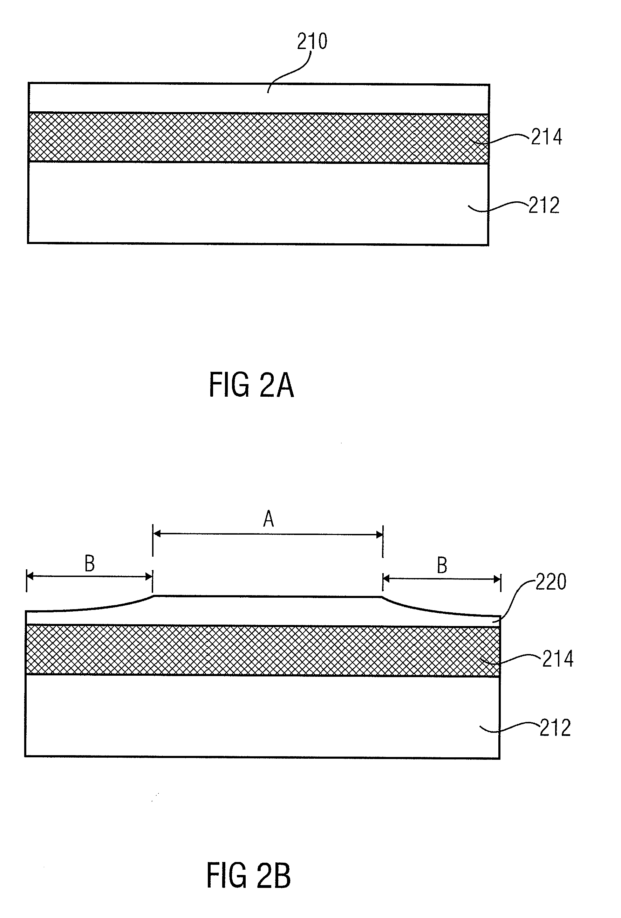

Die Fig. 2a bis 2f zeigen eine mögliche Prozessführung für den Sensorwafer, der im Wesentlichen später die Membran 110 definieren wird.

Fig. 2a zeigt als Beispiel ein so genanntes SOI-Substrat als eine mögliche Grundlage für den Sensorwafer. Das SOI-Substrat weist dabei beispielhaft eine einkristalline Siliziumschicht 210, die von einem Substrat (z.B. Siliziumsubstrat) 212 durch eine Oxidschicht 214 getrennt ist. Die einkristalline Siliziumschicht 210 wird dabei später die aktive Sensorschicht bilden und die Oxidschicht 214 wird auch als vergrabenes Oxid bezeichnet. Die im Folgenden näher erläuterte Prozessführung mittels eines SOI-Wafers ist dabei lediglich beispielhaft und andere einkristalline Halbleitermaterialien oder andere Halbleiter-Wafer können gleichermaßen verwendet werden.

Fig. 2b zeigt wie der Sensorbereich A entlang der einkristallinen Halbleiterschicht 210 dadurch definiert wird, dass entlang der Kontaktbereiche B (Randbereiche) eine Abdünnung der einkristallinen Siliziumschicht 210 erfolgt, so dass sich die Halbleiterschicht 220 ergibt. Die Abdünnung kann beispielsweise durch einen so genannten LOCOS-Prozess (LOCOS = local oxidation of silicon) an den Randbereichen B des späteren Sensors erfolgen. Durch diese Abdünnung sinkt gleichzeitig die thermische Leitfähigkeit der Randbereiche B, wodurch sich bei dem späteren Sensor eine bessere thermische Isolation zu den Abstandshaltern 150 ergibt.

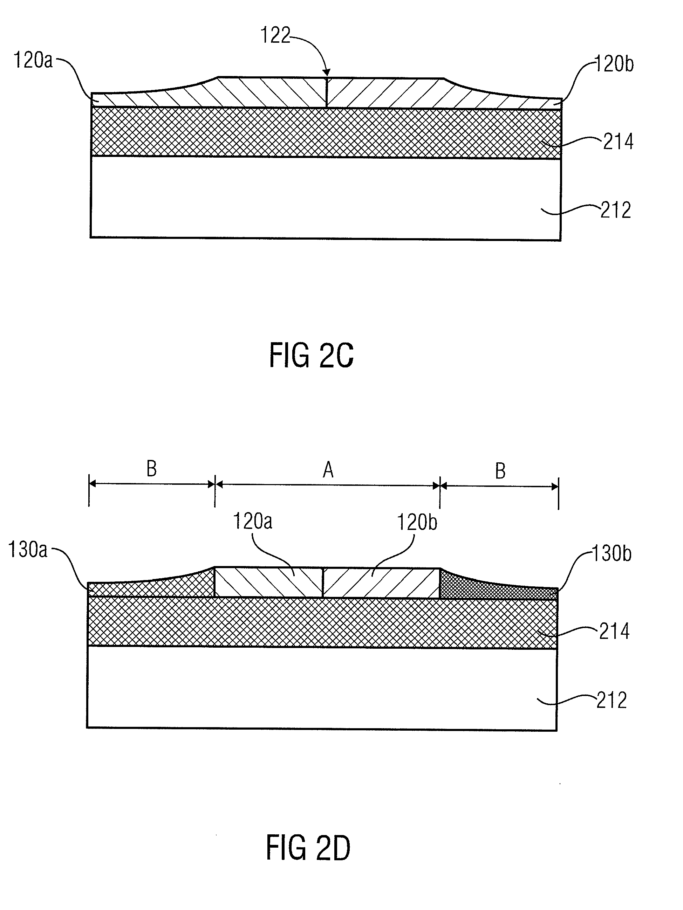

Fig. 2c zeigt wie durch eine Dotierung der Halbleiterschicht 220 der erste dotierte Bereich 120a und der zweite dotierte Bereich 120b gebildet werden kann, wobei beide dotierten Bereiche 120a, b komplementär dotiert sind, so dass sich an deren Grenzschicht 122 ein pn-Übergang ergibt. Die Dotierung des ersten Bereichs 120a kann beispielsweise durch eine Bor-Implantation erfolgen, wodurch das Halbleitermaterial n-leitend wird (n-Silizium) und die Dotierung des zweiten Bereiches 120b kann beispielsweise durch eine Phosphor-Implantation erreicht werden, wodurch sich ein p-leitender Halbleiter ergibt (p-Silizium). Somit wird der Sensor durch Implantationsprozesse in zwei unterschiedlich dotierte Bereiche 120a, b aufgeteilt, an deren Grenzschicht 122 sich eine Temperatur-sensitive Diode herausbildet.

Fig. 2d zeigt wie in einem Folgeschritt entlang der abgedünnten Bereiche B (Kontaktbereiche) eine Amorphisierung des Halbleitermaterials 120 erfolgt und dadurch sich ein erster Randbereich 130a, der in Kontakt zum ersten dotierten Bereich 120a steht und ferner ein zweiter Randbereich 130b, der in Kontakt zum zweiten dotierten Bereich 120b steht, herausbildet. Die Amorphisierung kann beispielsweise durch eine Argon-Implantation erfolgen, wodurch der Siliziumkristall gestört wird, so dass sich ein polykristallines oder amorphes Silizium herausbildet. Die Argon-Implantation kann dabei sowohl für das Bor-implantierte als auch für das Phosphor-implantierte Gebiet vorgenommen werden. Dementsprechend wird der n-leitende Halbleiter amorph und ebenfalls der p-leitende Halbleiter amorph. Dies führt dazu, dass die thermische Leitfähigkeit des Sensorelements entlang der Randbereiche B weiter deutlich reduziert wird und sich somit eine weitere Verbesserung der thermischen Isolation der Membran 110 zu den später herauszubildenden Abstandshaltern ergibt. Die Randbereiche B können dabei beispielsweise weiterhin ihre p- oder n-Charakteristik beibehalten, wobei die Reduktion der thermischen Leitfähigkeit durch die Amorphisierung des Materials (Störung oder Beschädigung der Gitterstruktur) erreicht wird. Anstatt der hier beispielhaft erwähnten Argon-Implantation kann die Amorphisierung auch eine andere Ionen-Implantation verwenden (z.B. unter Nutzung eines anderen nicht-dotierenden Edelgases).

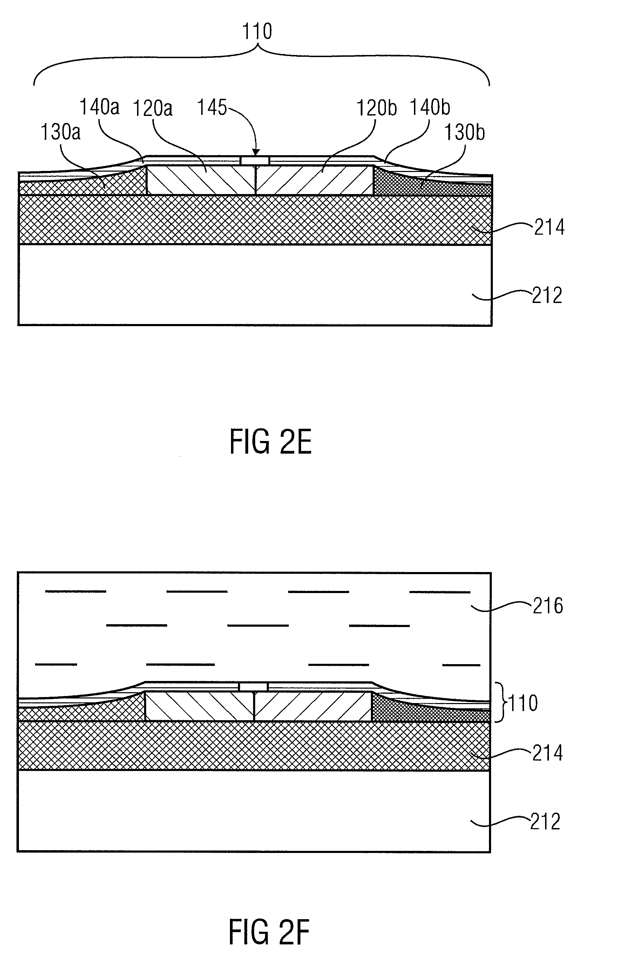

Fig. 2e zeigt wie in einem Folgeprozess eine erste leitfähige Schicht 140a auf den ersten Randbereich 130a und den ersten dotierten Bereich 120a ausgebildet wird und ferner eine zweite leitfähige Schicht 140b auf den zweiten dotierten Bereich 120b und den zweiten Randbereich 130b ausgebildet wird. Die erste und zweite leitfähige Schicht 140a, b sind dabei durch einen Spalt 145 voneinander elektrisch isoliert, wobei der Spalt 145 entlang des pn-Überganges 122 (Übergang zwischen den komplementär dotierten Bereichen 120a, b) ausgebildet wird.

Die leitfähige Schicht 140a, b vermeidet zum einen Reflexionen an der Bolometerschicht 110 und führt somit zu einer größtmöglichen Absorption. Um das zu erreichen werden große Teile des Sensors mit der leitfähigen Schicht 140 (z.B. einem dünnen Metallfilm) versehen, wobei der Spalt 145 eine elektrische Isolierung über die gesamte Sensorfläche sicherstellt. Als beispielhaftes Material kann Titannitrid für die leitfähige Schicht 140 verwendet werden. Ferner ist es optional möglich, dass sowohl über als auch unterhalb der leitfähigen Schicht 140 teilweise eine isolierende Schicht ausgebildet sein kann, um die gezeigten Schichten vor einer Degradation an der Umgebungsluft oder einem Ätzangriff während der weiteren Prozessführung zu schützen.

Neben der isolierenden Schicht kann in der gezeigten Schichtfolge zwischen der leitfähigen Schicht 140 und der Halbleiterschichten 120, 130 ebenfalls eine zusätzliche Isolationsschicht ausgebildet sein, wobei jedoch eine elektrische Kontaktierung der leitfähigen Schicht 120 mit den komplementär dotierten Bereichen 120a, b vorteilhafterweise ausgebildet ist. Die optionalen isolierenden Schichten können beispielsweise ein Siliziumnitrid oder Siliziumoxid oder intrinsisches amorphes Silizium aufweisen.

Da die Amorphisierung der Randbereiche 130a, b zu einer Beschädigung der Leitungsbandstrukturen des Halbleitermaterials führt, sollte die leitfähige Schicht 140 die komplementär dotierten Bereiche 120a, b elektrisch kontaktieren, um eine möglichst gute elektrische Leitfähigkeit oder elektrische Zuführung zu realisieren. Dadurch können nämlich die in Folge der Amorphisierung schlecht leitfähigen Randbereiche 130 elektrisch überbrückt werden, so dass eine Wärmeerzeugung in Folge eines erhöhten Ohmschen Widerstandes vermieden werden kann.

Fig. 2f zeigt einen Folgeschritt, bei dem auf die leitfähige Schicht 140 (die optionalen isolierenden Schichten werden im Folgenden nicht gezeigt) eine Verbindungsschicht (Bondschicht) 216 ausgebildet ist, wobei die Verbindungsschicht 216 für den folgenden Bondprozess mit dem Schaltungswafer genutzt wird und darüber hinaus als Opfermaterial dient, um den vorbestimmten Abstand D für das Bolometer einzustellen.

In einer abschließenden Prozessfolge wird somit der Sensorwafer, wie er in der Fig. 2e gezeigt ist mit einer zu bondenden Schicht 216 versehen, wobei die zu bondende Schicht 216 beispielsweise ein Siliziumoxid, Spin-on-Glass, amorphes Silizium oder eventuell eine adhäsive Zwischenschicht aus Polyimid oder BCB aufweisen kann, und mit der Oberseite nach unten gerichtet mit einem zweiten Wafer verbunden. Die Verbindung erfolgt somit entlang der beispielhaften Bondschicht 216, wobei der zweite Wafer (Schaltungswafer) ebenfalls eine bondbare Schicht aufweist entlang derer der Bondprozess geschehen kann. Der inaktive Teil des Sensorwafers (d. h. die Oxidschicht 214 oder vergrabenes Oxid und das beispielhafte Siliziumsubstrat 212) kann beispielsweise durch ein Abschleifen oder durch ein selektives Ätzen entfernt werden.

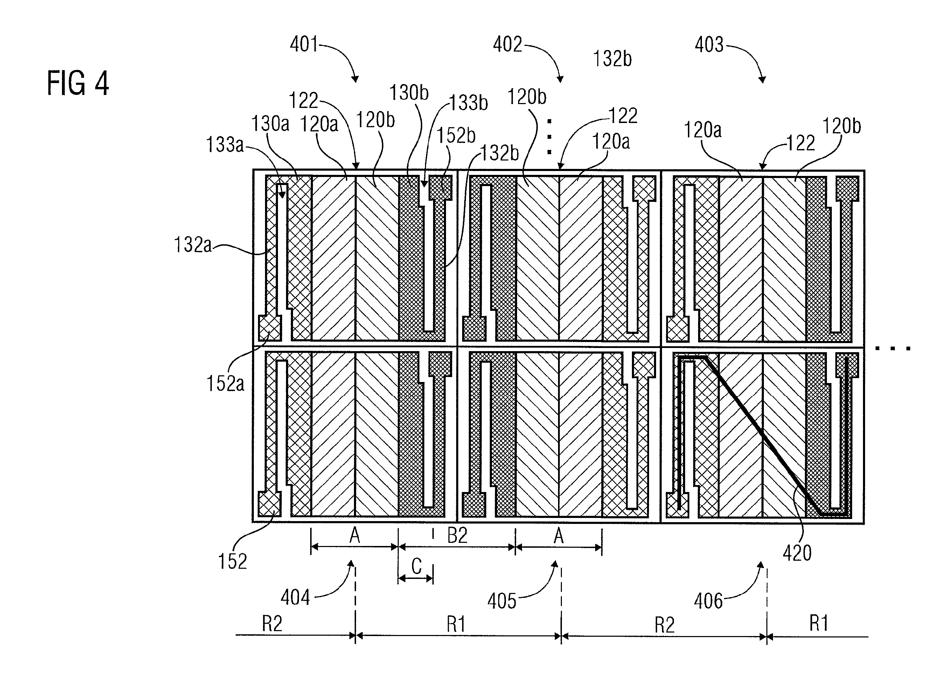

Durch die die Wafer (Sensorwafer und Schaltungswafer) verbindenden Zwischenschichten (Bondschicht 216) werden durch geeignete Ätz-/und Abscheideprozesse Metallkontakte hergestellt. Außerdem wird die Bolometergeometrie (siehe Fig. 4 unten) realisiert. Danach werden die nicht mehr benötigten Zwischenschichten (Bondschichten 216) selektiv entfernt, so dass eine über dem Schaltungswafer aufgehängte Membran 110 entsteht (siehe Fig. 1).

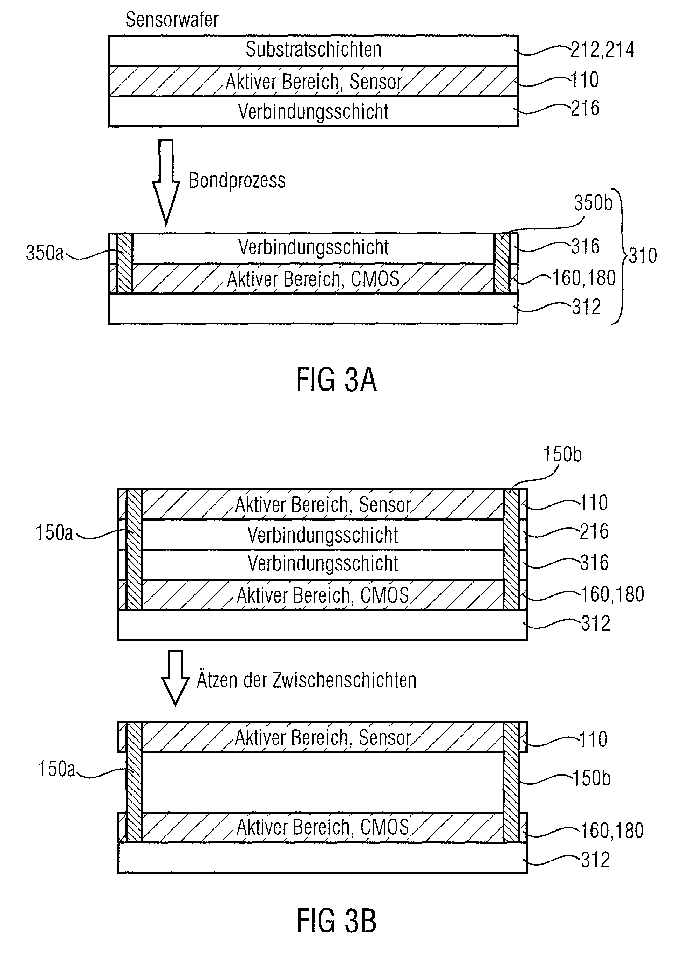

Die Fig. 3a, b zeigen die weitere Prozessierung nach der Fertigstellung des Sensorwafers und der Bereitstellung eines Schaltungswafers 310 (Schaltungssubstrat).

Fig. 3a zeigt zunächst den Bondprozess, bei dem der Sensorwafer mit dem Schaltungswafer 310 über einen Bondprozess miteinander verbunden werden. Der Sensorwafer weist dabei die Struktur, wie sie in der Fig. 2f gezeigt ist auf: die Verbindungsschicht 216, die Membran 110 (aktiver Bereich, Sensor) und einen Bulkbereich (die Oxidschicht 214 und das Substrat 212). Der Schaltungswafer 310 weist ebenfalls ein Substrat 312 auf, an dem sich ein aktiver Bereich (beispielsweise eine CMOS-Schaltung) anschließt, auf der schließlich ebenfalls eine Verbindungsschicht (Bondschicht) 316 ausgebildet ist. Bei dem Bondprozess wird die Bondschicht 216 des Sensorwafers mit der Verbindungsschicht 316 des Schaltungswafers 310 zusammengeführt. Vor dem Bondprozess können beispielsweise die Kontaktbereiche 350, an denen der aktive Bereich mit der beispielhaften CMOS-Schaltung kontaktiert werden, ausgebildet werden. Dies kann beispielsweise durch ein Ausbilden von Öffnungen (z. B. mittels Ätzen) in der Verbindungsschicht 316 des Schaltungswafers 310, die optional mit leitfähigem Material gefüllt werden können, passieren.

Fig. 3b zeigt zunächst im oberen Teil das Resultat des Bondprozesses wie er in der Fig. 3a gezeigt ist. Nach dem Bondprozess ergibt sich somit eine Schichtfolge, bei der die Verbindungsschicht 216 des Sensorwafers mit der Verbindungsschicht 316 des Schaltungswafers 310 in Kontakt steht, so dass die Membran 110 (Sensor) von dem aktiven Bereich (CMOS-Schaltung und Untergrundsubstrat 160) durch die beiden Verbindungsschichten 216 und 316 getrennt ist.

Nach dem Bondprozess können beispielsweise die Kontaktbereiche 350 des Schaltungswafers 310 durch einen Ätzprozess durch die Membran 110 und die Bondschicht 216 des Sensorwafers geöffnet werden und mit leitfähigem Material gefüllt werden, so dass sich die Abstandshalter 150a, b ergeben. Vor dem Ausbilden der Abstandshalter 150a, b sind beispielsweise der Bulkbereich des Sensorwafers, der die Oxidschicht 214 und das Substrat 212 umfasst, von dem Sensorwafer entfernt worden, so dass die Membran 110 (der aktive Bereich) freiliegt.

In einem abschließenden Prozessschritt werden die Bondschichten 216, 316 beispielsweise durch ein Ätzen entfernt, so dass sich die Membranstruktur, bei der der aktive Sensorbereich A als Membran 110 von den beiden Abstandshaltern 150a, b über dem Untergrundsubstrat 160 gehalten wird, ergibt (siehe Fig. 1).

Vor dem Bondprozess wie er in der Fig. 3a gezeigt ist, können auf den Schaltungswafer die Metallkontakte 350a, b ausgebildet werden, die eine Kontaktierung der beispielhaften CMOS-Schaltung (Auswerteeinheit 180) gewährleisten. Die Bondschichten 216 und 316 können beispielsweise ein Oxid, Silizium oder ein Polymer aufweisen. Der Bulkbereich (inaktiver Bereich der Substratschichten 212 und 214) kann beispielsweise durch ein selektives Ätzen entfernt werden und das Ausbilden der Abstandshalter 150a, 150b kann beispielsweise ein Ätzen zum Herausbilden von Kontaktlöchern (Öffnungen) durch die Bondschicht 216 und die Membran 110 und einem anschließenden Füllen der Kontaktlöcher mit leitfähigem Material umfassen. Ferner kann ein Schritt des Ätzens geschehen, der die Bolometergeometrie definiert (siehe Fig. 4).

Der beschriebene Bondprozess braucht nicht notwendigerweise mit Wafern durchgeführt werden, sondern kann auch für Substrate erfolgen, d.h. die Membrane mit einer Bondschicht und ein Schaltungssubstrat werden gebondet.

Für die gezeigte Prozessierung kommen somit eine Reihe von verschiedener konkreter Ausführungsmöglichkeiten in Frage. Als Opferschicht (Bondschichten 216, 316) kann wie gesagt beispielsweise Silizium verwendet werden, wobei in diesem Fall die aktiven Teile des Sensors mit einer Ätzbarriere geschützt werden sollten. Weitere Realisierungsmöglichkeiten bestehen in der (möglicherweise kombinierten) Verwendung von anderen Zwischenschichten und Haftvermittlern (Siliziumoxide, Polymere). Die Verbindung zwischen dem Sensor- und Schaltungswafer 310 erfolgt schließlich nur noch über dünne, metallische Pfosten (Abstandshalter 150). Ein großer Teil des Pixelelementes fungiert als optisch angepasster Absorber (für die zu erfassende Infrarotstrahlung). Die Randbereiche B sind dünn und aus nichteinkristallinem Material (amorphisiert) aufgebaut und stellen daher einen effektiven Wärmewiderstand dar. Die eigentliche Messung der Temperatur des Pixelelements erfolgt anhand der Temperaturabhängigkeit des elektrischen Widerstands der Diode (pn-Übergang) im zentralen Bereich des Sensors.

Fig. 4 zeigt eine Draufsicht auf einen Bolometer-Sensorarray, das beispielsweise sechs Pixelelemente 401, 402, 403, ... , 406 aufweist. Die Querschnittsansichten der Fig. 1 bis 3 beziehen sich dabei entlang der Querschnittslinie 420, die in dem sechsten Pixelelement 406 dargestellt ist. Das gezeigte Pixelarray aus sechs Elementen kann sich optional weiter in horizontaler als auch in vertikaler Richtung fortsetzen, so dass sich ein Infrarotsensor mit der gewünschten Auflösung (Anzahl von Pixeln) ergibt. Es ist ebenfalls möglich durch horizontale oder vertikaler Anordnungen einer Vielzahl von Bolometern auch ein Zeilenarray zu realisieren.

Wie in der Draufsicht der Fig. 4 zu ersehen ist, weist jedes Pixelelement die zwei komplementär dotierten Bereiche 120a, b auf, wobei sich die pn-Übergänge 122 in der gezeigten Darstellung entlang der vertikalen Richtung erstreckt. Senkrecht zu den vertikal angeordneten pn-Übergängen 122 erstrecken sich seitlich jeweils komplementär dotierte Bereiche 120a, b und daran anschließend die Randbereiche 130a, b, die durch eine Amorphisierung des einkristallinen Halbleitermaterials erzeugt wurden. Der erste Randbereich 130a stellt über einen Steg 132a einen Kontakt zu einem ersten Kontaktbereich 152a her. In analoger Weise kontaktiert der zweite Randbereich 130b über einen zweiten Steg 132b den zweiten Kontaktbereich 152b. Die Stege 132a, b verlaufen dabei beispielsweise parallel zu den pn-Übergängen 122 und sind durch schmale Spalten 133a, 133b von den Sensorbereichen A der Membran 110 getrennt.

Die zuvor genannten Ätzschritte zur Definierung der Bolometergeometrie umfassen dabei zum einen das Definieren der einzelnen Pixelelemente 401, ... , 406 als auch das Ausbilden der Spalte 133 und der Stege 132, die der besseren thermischen Isolation der Membran 110 dienen, so dass die entlang der pn-Übergänge 122 erfolge Messung möglichst in thermischer Isolation von den Kontaktbereichen 152 erfolgt. Die Abstandshalter 150 werden entweder später in den Kontaktbereichen 152 ausgebildet oder kontaktieren diese lediglich von unten, so dass sie in der Fig. 4 nicht ersichtlich sind.

Erfindungsgemäß erfolgt in der Sequenz der Pixelelemente 401, 402, 403, ... eine alternierende Abfolge von p- und n-dotierten Bereichen. Dies bedeutet: sofern der erste dotierte Bereich 120a (in der ersten Sensorzelle 401 der gezeigten Darstellung) einen n-dotierten Bereich und der zweite dotierte Bereich 120b einen p-dotierten Bereich umfasst, so ist in der zweiten Sensorzelle 402 der p-dotierte Bereich auf jener Seite angeordnet, die der ersten Sensorzelle 401 zugewandt ist und der n-dotierte Bereich auf jener Seite angeordnet, der der dritten Sensorzelle 403 zugewandt ist. In der Fig. 4 ergibt sich somit von links nach rechts die Dotierfolge: in der ersten Sensorzelle wird zunächst der Bereich 120a gefolgt vom zweiten Bereich 120b und in der zweiten Sensorzelle 402 ist zunächst der zweite Bereich 120b und dann der erste Bereich 120a angeordnet sind, und schließlich in der dritten Sensorzelle 403 wiederum wie in der ersten Sensorzelle 401 zuerst der erste Bereich 120a und dann der zweite Bereich 120b ausgebildet ist. Damit ist es möglich, bei der Prozessierung des Sensorwafers in einem ersten Dotierungsbereich R1 zwischen dem pn-Übergang 122 des ersten und zweiten Sensorelements 401, 402 eine gleiche Dotierung zu wählen und in einem zweiten Dotierungsbereich R2 zwischen dem pn-Übergang des zweiten Sensorelements 402 und dem pn-Übergang 122 des dritten Sensorelements 403 eine dazu komplementäre Dotierung zu wählen. Diese Dotierfolge kann sich horizontal für einen gesamten Wafer fortsetzen. Das hat den Vorteil, dass dadurch die Dotierungen großflächig erzeugt werden können und die Dotierungen sich in vertikaler Richtung nicht zu ändern brauchen. Das vierte Sensorelement 404 weist somit die gleiche Dotierungsfolge (erste Bereich 120a links und der zweite Bereich 120b rechts) auf wie das erste Sensorelement 401 und das fünfte Sensorelement 405 die gleichen Dotierungen wie das zweite Sensorelement 402. Die so gewählte Dotierfolge bedeutet allgemein, dass vertikal benachbarte Bolometer (Sensorelemente) gleiche Dotierprofile und horizontal benachbarte Bolometer komplementäre Dotierprofile aufweisen.

Sofern die Dotierungen ausgebildet sind, können zwischen den Sensorgebieten A, die sich symmetrisch um die pn-Übergänge 122 erstrecken, in einem Folgeschritt die amorphisierten Randbereiche entlang der Gebiete B2 herausgebildet werden. Nach der Amorphisierung der Randbereiche B2 kann schließlich durch Ätzprozesse beispielsweise eine Strukturierung in der oben dargestellten Form erfolgen, wobei die Stege 132 und die Spalten 133 erzeugt werden. Dieser Ätzprozess erfolgt aber erst nach dem Bonden des Sensorwafers mit dem Schaltungswafer 310, der in der hier gezeigten Darstellung unterhalb des Sensorwafers angeordnet ist.

Nach dem Bondprozess können die Kontaktbereiche 152 über einen Ätzprozess geöffnet werden, so dass eine metallische Verbindung zu den darunter liegenden Metallkontakten 350 der Auswerteschaltung 180 möglich ist und sich dadurch die Abstandshalter 150 herausbilden.

Die Dotierung einschließlich der thermischen Ausheilung stellt im Allgemeinen einen Hochtemperaturprozess dar, der sich negativ auf eine Auswerteschaltung 180 auswirken würde. Daher ist die gezeigte Prozessführung, bei der zunächst die Sensormembran separat prozessiert wird, in deren Verlauf die dotierten Bereiche 120 ausgebildet werden, vorteilhaft. Diese Hochtemperaturprozesse erfolgen dadurch in einem separaten Wafer, der noch keinen Kontakt zu dem Schaltungswafer aufweist.

Die Fig. 4 zeigt somit die laterale Geometrie des Sensorelements in einer Draufsicht, wobei ebenfalls der Schnitt der vorherigen Abbildung eingezeichnet ist. Die gewählte Prozessierung erfolgt in der Regel nicht anhand eines einzelnen Sensors, sondern zur Realisierung beispielsweise einer hoch auflösenden Kamera in Form eines so genannten Arrays von Pixeln (z. B. 640 x 480). Die vorgestellte Prozessführung weist somit den zusätzlichen Vorteil auf, dass nur geringe Anforderungen an die räumliche Genauigkeit der Justage der einzelnen Strukturen zueinander gestellt werden brauchen. Die Dotierung der einzelnen Bereiche kann beispielsweise anhand über breiter Streifen erfolgen (z. B. zwischen dem pn-Übergang 122 des ersten Sensorelements 401 und dem pn-Übergang 122 des zweiten Sensorelements 402). Auf diese Weise beeinträchtigt eine vertikale Dejustage das Funktionieren des Bauelements nicht (da die vertikal zueinander angeordneten Sensorpixel eine gleiche Dotierfolge aufweisen). Auch in horizontaler Richtung besteht eine Toleranz, die für die aktuelle Herstellungstechnologie ausreichend ist.

Die thermische Isolierung erfolgt wie oben beschrieben über dünne Stege 132 an jeweils zwei Seiten jedes Pixels 401, 402, .... Durch diese Art der Prozessführung sind die Stege 132 dünner als der zentrale Bereich des Pixels (der im Wesentlichen durch die Sensorfläche A gegeben ist). Außerdem ist das Halbleitermaterial entlang der Stege 132 amorph ausgebildet. Diese beiden Eigenschaften ermöglichen es, die thermische Leitfähigkeit im Vergleich zu homogenen einkristallinen Sensoren deutlich zu verringern - ohne, dass die optischen Eigenschaften des Systems oder der Flächenbedarf ungünstig beeinträchtigt werden.

Beispielsweise ist entlang des ersten Dotierungsgebietes R1 (Implantationsgebiets) eine Phosphor-Dotierung vorgenommen, an die sich in dem zweiten Dotierungsgebiet R2 eine beispielhafte Bor-Dotierung anschließt. Diese alternierenden Dotierungen setzen sich in horizontaler Richtung fort - bleiben jedoch in vertikaler Richtung gleich. In jedem der Dotierungsbereiche R1, R2 sind beispielsweise möglichst mittig die Randbereiche B2 ausgebildet, in denen beispielsweise eine Argon-Implantation vorgenommen wird, so dass dort das einkristalline Halbleitermaterial amorphisiert wird. Ein horizontaler Toleranzbereich C bei der Amorphisierung stellt zum einen sicher, dass entlang der Stege 132 auf jeden Fall amorphes Halbleitermaterial ausgebildet ist und zum anderen, dass sich in der Mitte der Sensorfläche A ein pn-Übergang 122 herausbildet. Da sich die Dotierung in vertikaler Richtung nicht ändert, besteht auch dort eine Justagetoleranz. Es ist zu beachten, dass die Amorphisierung in den Bereichen B2 durch eine Implantation eines beispielhaften Edelgases wie Argon vorgenommen wird, so dass dort das Halbleitermaterial sowohl Phosphor- oder Borals auch Argon-Atome aufweist. Es wird somit direkt das p-oder n-dotierte Gebiet amorphisiert.

Ausführungsbeispiele können abschließend somit wie folgt zusammengefasst werden. Das Bolometer weist als wesentliche Strukturmerkmale einen einkristallinen Sensor auf, der durch amorphe und gedünnte Randbereiche (Stege 132) gehalten wird. Durch das in der Fig. 4 gezeigten Dotierprofil ergibt sich eine Justagetoleranz, die insbesondere bei der Prozessierung von hoch auflösenden Pixelarrays vorteilhaft ist. Ferner ist eine Anpassung des Flächenwiderstandes and den Wellenwiderstand über die leitfähige Schicht 140 möglich.

Ausführungsbeispiele der vorliegenden Erfindung können damit auch wie folgt definiert werden. Ein Diodenbolometerarray weist einkristalline laterale Dioden auf, die durch einen geeigneten Bondprozess mit einem isotropen Ätzschritt auf zwei Pfosten (Abstandshalter 150) über eine CMOS-Ausleseschaltung (Auswerteschaltung 180) aufgehängt wird. Optional weist die Diode zusätzlich eine Titannitridschicht 140 auf, die beispielsweise für die Einstellung des gesamten Flächenwiderstands auf 377 Ohm/sq. genutzt werden kann ("sq." bezieht sich dabei auf die Fläche oder genauer auf das Verhältnis der Länge zur Breite der Fläche). Diese leitfähige Schicht 140 ist nur an einer schmalen Stelle 145 unterbrochen. Diese Stelle kann direkt über dem pn-Übergang der Diode liegen oder auch - wenn eine isolierende Zwischenschicht (z. B. aus Siliziumoxid, Siliziumnitrid etc.) verwendet wird - an einer beliebigen anderen Stelle angeordnet sein. Bei Ausführungsbeispielen werden die Randbereiche 130 amorphisiert um dadurch entlang der Kontaktarme (Stege 132) eine bessere thermische Isolierung zu erreichen. Ferner können optional die Kontaktarme durch einen beispielhaften LOCOS-Prozess gedünnt werden, was ebenfalls die thermische Leitfähigkeit verringert.

Hinsichtlich der Justagefreiheit weist die erfindungsgemäße Prozessierung ein optimiertes Layout auf, das in der Fig. 4 gezeigt ist. Die Justagefreiheit bezieht sich dabei nicht nur auf die Prozessierung der Membran (z.B. bei der Dotierung, Amorphisierung, Strukturierung, etc.), sondern auch auf den Prozess des Waferbondens (Herstellung eines Waferverbundes), der oft eine Justageungenauigkeit von beispielsweise 5 µm aufweist. Das optimierte Layout, bei dem horizontal benachbarte Pixel immer vertauschte p/n-Seiten aufweisen, erlaubt somit ein sicheres Waferbonden. Beispielsweise kann der Waferverbund eine Ungenauigkeit aufweisen, die innerhalb des Toleranzbereich C in der Fig. 4 liegt, ohne dass der Waferverbund beeinträchtigt wird. Mit herkömmlichem Layout wäre das Waferbonden kaum realisierbar.

Bei der erfindungsgemäßen Prozessführung kann ferner zwischen dem einkristallinen Halbleitermaterial 120 und der reflexionsmindernden leitfähigen Schicht 140 eine Isolationsschicht eingebracht werden. Es ist ebenfalls möglich, dass die leitfähige Schicht 140 selbst von einer solchen Isolationsschicht bedeckt sein kann. Wie ausführlich beschrieben gibt es verschiedene Möglichkeiten die beiden Wafer zu bonden, wobei ein direktes Bonden, ein Bonden mit organischen und anorganischen Zwischenschichten, oder auch mittels anderer Bondmaterialien erfolgen kann. Wichtig bei dem Bondprozess ist es, dass alle Hochtemperaturprozesse, die an der Membran durchzuführen sind, vor dem Bonden ausgeführt werden, so dass eine Auswerteschaltung 180, die sich in dem Untergrundsubstrat 160 befinden kann, nicht von den Hochtemperaturprozessen geschädigt wird. Dies ist insbesondere deswegen wichtig, da die Auswerteschaltung 180 möglichst unterhalb der Membran 110 angeordnet sein sollte, so dass der Sensorarray eine möglichst kompakte Form aufweisen kann und keine seitlich anzuordnende Schaltung erforderlich ist.

Die hier vorgestellten Ausführungsbeispiele wiesen eine Membran auf, die zusammen mit einem reflektierenden Untergrund eine stark absorbierende Resonatorstruktur bildet. Das Sensormembran dient dabei als Absorber und wird direkt durch die Strahlung erwärmt. Dies ist insofern vorteilhaft, als die technologisch zum Teil aufwändige und die Eigenschaften der Gesamtstruktur häufig degradierende Implementation einer zusätzlichen absorbierenden Struktur (z. B. einer weiteren, thermisch angekoppelten Membran) entfällt. Die Ausführungsbeispiele vereinigen daher in neuartiger Art und Weise die elektrischen Vorteile eines Diodenbolmeters mit hervorragenden optischen Eigenschaften und einer geringen thermischen Masse.

Obige Ausführungsbeispiele betrafen somit unter anderem auch ein Bolometerarray mit einer Vielzahl von Bolometer nach einem der vorhergehenden Ausführungsbeispiele, die vertikal und/oder horizontal benachbart angeordnet sind, wobei die komplementär dotierten Bereiche 120a, 120b horizontal benachbart ausgebildet sind. Dabei können vertikal benachbarte Bolometer gleiche Dotierprofile aufweisen und horizontal benachbarte Bolometer komplementäre Dotierprofile aufweisen.

Obige Ausführungsbeispiele betrafen aber auch ein Verfahren zum Herstellen eines Bolometers mit einem Bilden einer Halbleitermembran 110 mit einem einkristallinen Abschnitt 120; einem Bilden einer Bondschicht 216 auf der Halbleitermembran 110; einem Bereitstellen eines Schaltungssubstrats 310, das eine Auswerteschaltung 180 aufweist; einem Bonden der Halbleitermembran 110 und des Schaltungssubstrats 310 entlang der Bondschicht 216; einem Bilden von Abstandshaltern 150; und einem Entfernen der Bondschicht 216. Dabei kann der Schritt des Bildens der Halbleitermembran 110 folgende Schritte umfasst, nämlich Bereitstellen eines Schichtstapels mit einer einkristallinen Halbleiterschicht 210, einer Oxidschicht 214 und einer Substratschicht 212; Dünnen der einkristallinen Halbleiterschicht 210 entlang von Randbereichen; Dotieren der einkristallinen Halbleiterschicht 210, um komplementär dotierte Bereiche 120a, 120b zu erzeugen; Amorphisieren der gedünnten Randbereiche; und Bilden einer leitfähigen Schicht 140 auf die Randbereiche B und teilweise auf die komplementär dotierten Bereiche 120. Dabei kann dann das Dünnen durch einen LOCOS-Prozess ausgeführt werden, und/oder das Verfahren ferner den Schritt des Bildens einer Isolierschicht aufweisen, wobei die Isolierschicht zwischen der leitfähigen Schicht 140 und der Randbereiche 130 oder zwischen der leitfähigen Schicht 140 und der komplementär dotierten Bereiche 120 ausgebildet wird. Ferner kann ein Bilden einer weiteren Isolierschicht vorgesehen sein, wobei die weitere Isolierschicht auf die leitfähigen Schicht 140 ausgebildet wird. Das Bilden der leitfähigen Schicht 140 kann mit einer solchen Schichtdicke ausgeführt werden, dass die Halbleitermembran 110 als Flächenwiderstand den Wellenwiderstand einer Infrarotstrahlung in Luft aufweist. Das Amorphisieren kann ein Implantieren von Ionen umfassen. Das Bilden der Halbleitermembran 110 kann ein Bilden eines Sensorwafers umfassen, wobei auf dem Sensorwafer eine Vielzahl von Halbleitermembranen angeordnet werden, so dass benachbarte Bolometerelemente ein gleiches Dotierprofil in einer lateralen Richtung und ein komplementäres Dotierprofil entlang einer dazu senkrechten lateralen Richtung aufweisen. Und schließlich kann das Bereitstellen eines Schaltungssubstrats ein Bereitstellen eines Schaltungswafers mit einer Vielzahl von Auswertschaltungen umfassen und das Bonden einen Waferbondprozess umfassen, so dass jede Halbleitermembran mit einer zugehörigen Auswerteschaltung elektrisch verbunden wird.

## Patentansprüche

1. Bolometer mit:
einem Untergrundsubstrat (160);
einer Halbleitermembran (110) mit einem einkristallinen Abschnitt (120); und
einem Abstandshalter (150), um die Halbleitermembran (110) in einem vorbestimmten Abstand (D) von dem Untergrundsubstrat (160) zu halten,
wobei komplementär dotierte Bereiche (120a, 120b) des einkristallinen Abschnitts eine Diode bilden und der vorbestimmte Abstand (D) einem Viertel einer Infrarotwellenlänge (λ) entspricht,
wobei die Halbleitermembran (110) die Abstandshalter (150) über einen ersten und zweiten Randbereich (130a, 130b), die Stege (132) zur thermischen Isolation der Halbleitermembran aufweisen, kontaktiert, und
wobei das Bolometer ferner eine Auswerteschaltung (180) aufweist und zumindest ein Teil der Auswerteschaltung (180) in dem Untergrundsubstrat (160) lateral zwischen dem ersten und zweiten Abstandshalter (150a, 150b) angeordnet ist.

2. Bolometer nach Anspruch 1, das ferner einen intrinsischen Bereich (120i) aufweist und der intrinsische Bereich lateral entlang der Halbleitermembran (110) zwischen den komplementär dotierten Bereichen (120a, 120b) ausgebildet ist, so dass der einkristalline Abschnitt (120) eine PIN-Diode bildet.

3. Bolometer nach Anspruch 1 oder Anspruch 2, bei dem das Untergrundsubstrat (160) eine Reflexionsschicht (170) aufweist, so dass einfallende Infrarotstrahlung an der Reflexionsschicht (170) in Richtung der Halbleitermembran (110) reflektierbar ist.

4. Bolometer nach einem der vorhergehenden Ansprüche, bei der die komplementär dotierten Bereiche (120a, 120b) ein Sensorgebiet (A) bilden, und ferner als Absorptionsmedium für die einfallende Infrarotstrahlung dienen.

5. Bolometer nach einem der vorhergehenden Ansprüche, bei dem die Halbleitermembran (110) ferner eine erste und zweite leitfähige Schicht (140a, 140b), die voneinander durch einen Spalt (145) elektrisch isoliert sind, aufweist,
wobei die erste leitfähige Schicht (140a) den ersten dotierten Bereich (120a) kontaktiert und die zweite leitfähige Schicht (140b) den zweiten dotierten Bereich (120b) kontaktiert, und wobei der Spalt (145) entlang eines pn-Übergangs (122) zwischen den komplementär dotierten Bereichen (120a, 120b) ausgebildet ist.

6. Bolometer nach Anspruch 5, bei dem die komplementär dotierten Bereiche (120a, 120b) auf einer dem Untergrundsubstrat (160) abgewandten Seite der leitfähigen Schicht (140) angeordnet sind.

7. Bolometer nach Anspruch 5 oder Anspruch 6, bei dem die leitfähige Schicht (140) ausgebildet ist, so dass die Halbleitermembran (110) einen Flächenwiderstand zwischen 200 Ohm/Quadratfläche und 700 Ohm/Quadratfläche aufweist.

8. Bolometer nach einem der vorhergehenden Ansprüche, bei dem der erste und zweite Randbereich (130a, 130b) amorphisiertes dotiertes Halbleitermaterial aufweisen.

9. Bolometer nach einem der vorhergehenden Ansprüche, bei dem die Stege (132) eine im Vergleich zur Halbleitermembran (110) verringerte Schichtdicke aufweisen.

10. Bolometer nach einem der vorhergehenden Ansprüche, bei dem zwischen den Stegen (132) und den dotierten Bereichen (120) Spalte (133) ausgebildet sind.

11. Bolometer nach einem der vorhergehenden Ansprüche, das ferner eine Isolierschicht aufweist und die Isolierschicht zwischen der leitfähigen Schicht (140) und den komplementär dotierten Bereichen (120) angeordnet ist oder auf der Halbleitermembran (110) ausgebildet ist.

12. Bolometerarray mit:
einer Vielzahl von Bolometer nach einem der Ansprüche 1 bis 11, die vertikal und/oder horizontal benachbart angeordnet sind,
wobei die komplementär dotierten Bereiche (120a, 120b) horizontal benachbart ausgebildet sind.

13. Verfahren zum Herstellen eines Bolometers mit:
Bilden einer Halbleitermembran (110) mit einem einkristallinen Abschnitt (120);
Bilden einer Bondschicht (216) auf der Halbleitermembran (110);
Bereitstellen eines Schaltungssubstrats (310), das eine Auswerteschaltung (180) aufweist;
Bonden der Halbleitermembran (110) und des Schaltungssubstrats (310) entlang der Bondschicht (216);
Bilden von Abstandshaltern (150); und
Entfernen der Bondschicht (216).

14. Verfahren nach Anspruch 13, das ferner ein Bilden eines intrinsischen Abschnittes (120i) aufweist, wobei der intrinsische Abschnitt (120i) zwischen den komplementär dotierten Bereichen (120a, 120b) gebildet wird.

15. Verfahren nach Anspruch 13 oder Anspruch 14, bei dem der Schritt des Bildens der Halbleitermembran (110) folgende Schritte umfasst:
Bereitstellen eines Schichtstapels mit einer einkristallinen Halbleiterschicht (210), einer Oxidschicht (214) und einer Substratschicht (212);
Dünnen der einkristallinen Halbleiterschicht (210) entlang von Randbereichen (B);
Dotieren der einkristallinen Halbleiterschicht (210), um komplementär dotierte Bereiche (120a, 120b) zu erzeugen;
Amorphisieren der gedünnten Randbereiche (B); und
Bilden einer leitfähigen Schicht (140) auf die Randbereiche (B) und teilweise auf die komplementär dotierten Bereiche (120).
